**Europäisches Patentamt**

**European Patent Office**

**Office européen des brevets**

(19)

(11) Publication number: **0 063 878**
**A1**

# (12) EUROPEAN PATENT APPLICATION

(21) Application number: **82301799.1**

(22) Date of filing: **05.04.82**

(51) Int. Cl.³: **G 11 C 11/56, G 11 C 27/00**

(30) Priority: **04.04.81 GB 8110608**

(43) Date of publication of application: **03.11.82**
**Bulletin 82/44**

(84) Designated Contracting States: **AT BE CH DE FR GB IT LI LU NL SE**

(71) Applicant: **MICRO-XENO LIMITED, Xeno House 224 Wellington Road, Perry Barr Birmingham B20 2QL (GB)**

(72) Inventor: **Khan, Bart Haring, Xeno House 224 Wellington Road, Perry Bar Birmingham, B20 2QL (GB)**

(74) Representative: **Skerrett, John Norton Haigh et al, H.N. & W.S. SKERRETT Rutland House 148 Edmund Street, Birmingham B3 2LQ (GB)**

(54) **Method and apparatus for processing and packaging digital data.**

(57) A digital data memory device converts digital data bytes into analogue voltages which are then mapped to time-dependent base reference quantities also in analogue form derived from a digital base reference counter 24. The mapped analogue data signals from successive data units are then deposited on a capacitor storage element 12 to build up a charge packet of compressed data and parameters relating to the stored data are held in digital form in parameter registers 62. The system is dynamically organised under programmed control of a microcontroller unit 14. Mapping of the data involves time domains and unusully high degrees of compression and storage capacity are achieved.

## METHOD AND APPARATUS FOR
## PROCESSING AND PACKAGING DIGITAL DATA

### TECHNICAL FIELD

This invention relates to the field of computer technology and of digital systems, including communications, involving data processing, storage and/or transmission.

More particularly, the invention concerns a method and means for processing and packing digital data and provides, inter alia, a new form of memory for mass storage of digital data.

The term "digital data" is herein used to denote any electrical signal in multi-bit digital form expressing a number generally representative of information.

The invention also concerns electrical signal processing circuitry arrangements.

### BACKGROUND ART

Various forms of devices and systems for the collection or mass storage of digital data are widely used in the field of digital data processing and computer technology, ranging from magnetic recording media systems to solid state semi-conductor devices and systems, providing read/write facilities and random access.

There is, however, a continual search and need for improvements in such known devices and systems, especially when implemented as digital data memories, particularly in respect of storage capacity, low production costs and small physical dimensions, reliability and physical stability, ease and speed of operation, etc.

## Disclosure of Invention

The present invention introduces new concepts into the field of data packaging and storage and is adapted to provide most exceptional degrees of compression of data.

Digital data is converted into analogue form to permit of compression in the time domain but as will be seen from the subsequent description of one embodiment a remarkable degree of precision and control is maintained under dynamic conditions and programmed control, and the invention includes many new features, innovative ideas and circuitry.

0063878

## BRIEF DESCRIPTION OF DRAWINGS

By way of example, one particular preferred embodiment of the invention for processing, packaging and storing digital data, constructed as a memory module, is illustrated in the accompanying drawings, wherein:-

FIGURE 1 is a diagram showing schematically the general layout in the memory module;

FIGURE 2 is a diagram relating to interfacing with a host computer;

FIGURE 3 is a further diagram of part of the internal architecture or organisation of the system;

FIGURE 4 is a diagram of circuitry of a single "node" stage, including dynamic elements thereof;

FIGURE 4a is a diagram of simplified equivalent circuits of the node stage of FIGURE 4;

FIGURE 5 is a diagram of a Base Address Counter circuit;

FIGURE 6 is a Table relating to the Base Address Counter;

FIGURE 7 is a Table indicating the structure of the data store locations or addresses with respect to the "nodes";

FIGURE 8 is a diagram relating to an analogue-to-digital converter stage;

FIGURES 9a, 9b and 9c are diagrams of an 8-bit, a 12-bit and a 4-bit D/A converter respectively;

FIGURES 10 and 11 are circuit diagrams of different sections of a time based analogue function generator stage;

FIGURES 12a, 12b and 12c are explanatory diagrams relating to the analogue function generator;

FIGURE 13 is a schematic diagram of the functional circuit of a node;

FIGURE 14 is a diagram relating to the switching of a node;

FIGURE 15 is an explanatory graph;

FIGURES 16a, 16b and 17 are further explanatory diagrams; and

FIGURE 18 is a diagram indicating the manner in which the memory system may be used in connection with the transmission of data in communications applications.

## DESCRIPTION OF PREFERRED EMBODIMENT

### Preliminary Outline

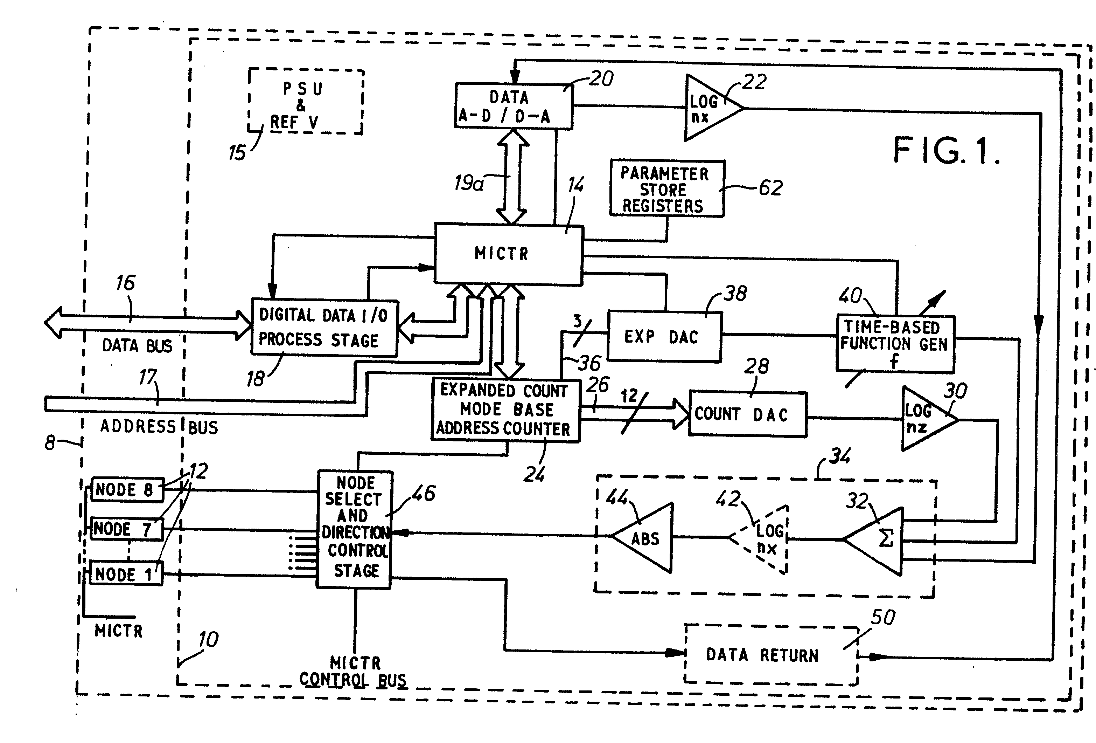

The memory module 8 as illustrated in FIGURE 1 of the drawings is made up of a main control and driver processing unit assembly 10 and a plurality of dynamic storage unit sub-assemblies 12, herein termed "nodes", which together with an internal power supply unit and reference voltage source 15 may all be compactly contained in a housing structure of small physical dimensions (for example, 220 x 220 x 180mm).

The memory 8 in this embodiment is designed for use as a peripheral unit interfaced with a host computer to provide a non-volatile high density bulk buffer storage system for digital data in the form of 8-bit bytes.

The processing operations and dynamic functioning of the memory module are under the overall supervisory control of a micro controller 14 (abbreviated MICTR) which includes a selected microprocessor such as, for example, that currently available under the reference MC 68000 L (Motorola), together with associated RAM and ROM storage. The MICTR is also linked to a matrix array of non-volatile latch registers providing a 256 x 32 bit digital parameter store 62 which represents an ultimate storage domain of the device as will hereinafter be apparent.

Other principal functional processing elements of the memory module, incorporated in the main control and driver processing unit assembly 10, include a digital data input/output process stage 18, a data converter 20 having both digital-to-analogue (D/A) converter and analogue-to-digital (A/D) converter stages under the control of the MICTR, and a digital base address counter 24 which gives an output in expanded scientific mode and has an overall count-up range of at least 0 to $999 \times 10^{7}$.

The digital data is input to, and output from, the memory module by way of a conventional bi-directional tri-state buffered external data bus 16 of the host computer.

During input, the data bytes are passed sequentially, generally as a block from the host computer and organised as a "file" identified by a specific coded "file name", to the digital data I/0 process stage 18 via an I/0 control gate. The incoming bytes can be temporarily stored in the ordered form of a queue and the bit voltage levels can be adjusted before being passed, under the control of a direct memory addressing (DMA) controller, to a data (source) buffer register in the RAM within the MICTR. Subsequently, however, each byte in sequence is processed individually in a particular time period in synchronism with the clock-controlled machine cycle of the system until all the file input is dealt with and stored.

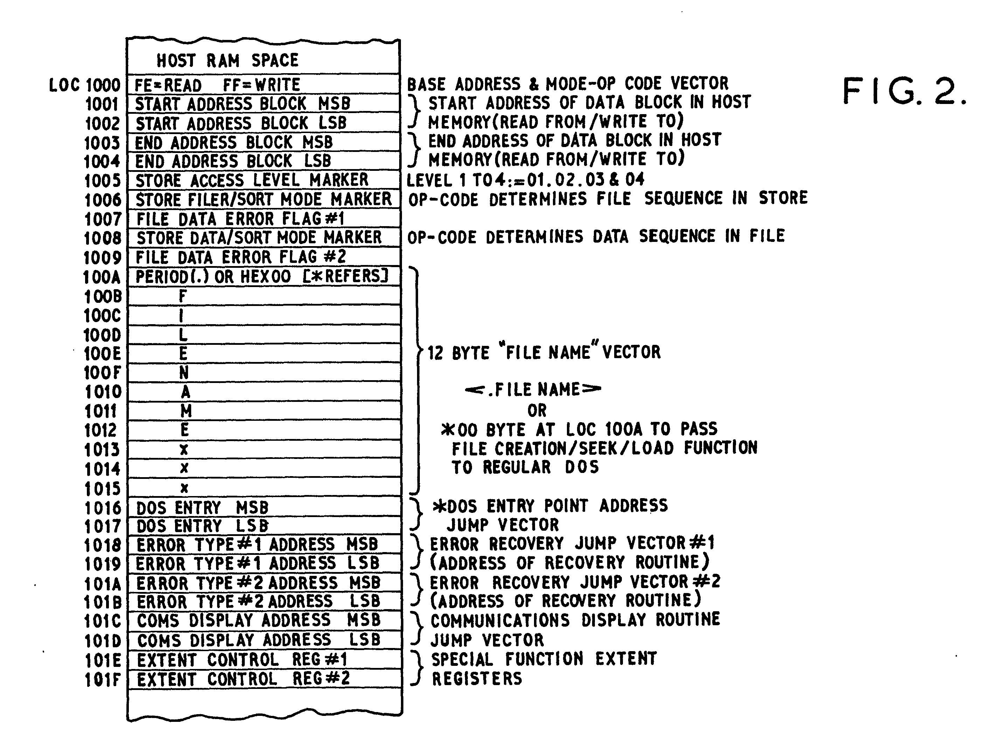

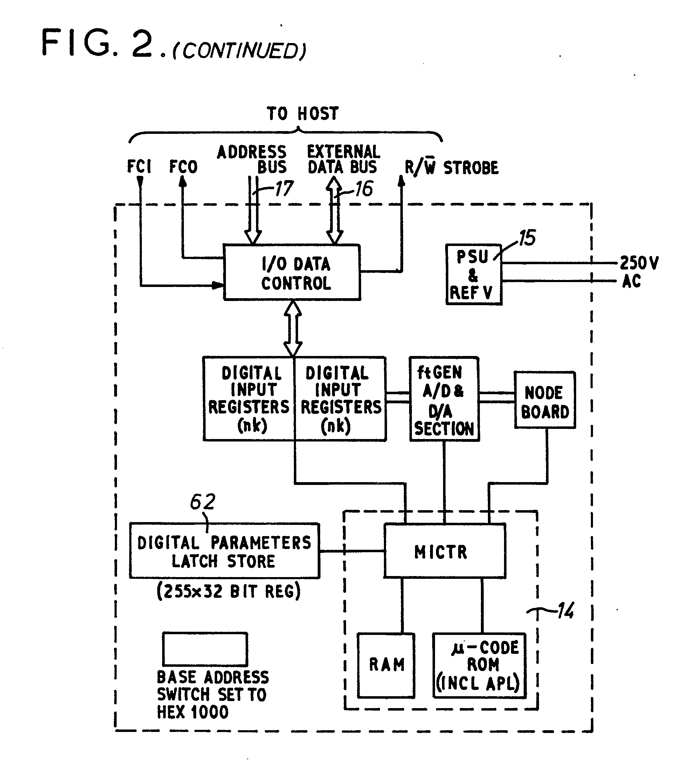

In interfacing with the host computer, the memory module is addressed via a host address bus 17 and at least 32 bytes will be mapped within the host computer for carrying out the addressing function. This is indicated in FIGURE 2 which is a diagram showing the memory module 8 and the relevant section of a map of part of the host RAM in a typical interfacing arrangement.

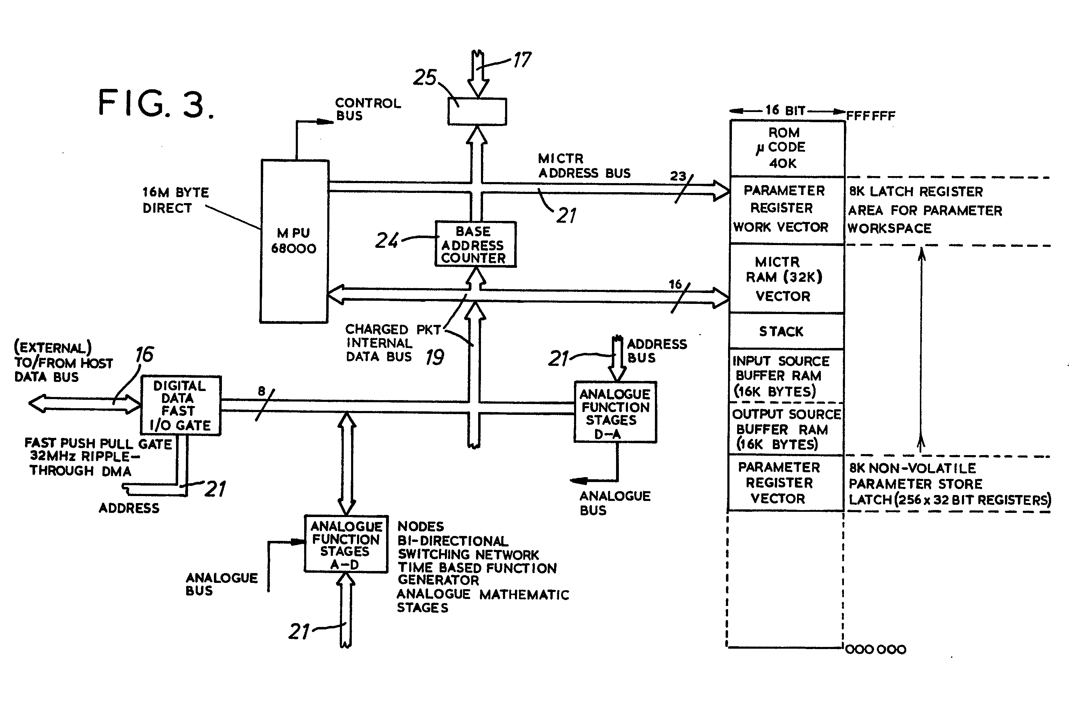

In this diagram of FIGURE 2, a grouping of the functional blocks in the memory module is shown which is slightly different from that in the main block diagram of FIGURE 1, but it will be understood that these diagrams are only schematic to illustrate the functional processes and can be arranged in different ways for convenience; they do not necessarily relate to the actual physical layout of the functional components and circuitry or a complete and invariable signal routing plan. Similarly, in FIGURE 3 which is a further diagram illustrating the internal organisation of the module including the bus systems in relation to the microprocessor and main RAM store of the MICTR, the Base Address Counter 24, digital data I/0 gate of the data I/0 process stage 18, the D/A and A/D converter stages and other functional parts. It will be appreciated that in accordance with conventional microprocessor and computer technology, the internal busses may each form continuous highways carrying a variety of signals for the different stages linked therewith, the signals being routed appropriately by the control logic of the system. In this case, it may be noted that the external data bus 16 connecting with the host enters the internal data bus 19 through the I/O gate, and the external host address bus 17 may also be connected in to the internal address bus 21 through a suitable protective gating arrangement 25.

The method of storage of data within the memory module can be selectable and after selection will be under the control of the host computer CPU; possible filing and search techniques include sequential, block, binary and indexed sequential.

As will hereinafter become more clearly apparent, in use a "write" operation involves transforming the digital data bytes with high precision into corresponding voltage analogue data signals which are dynamically compressed, mapping the data (digitally and in analogue form) onto a base reference derived from the base address counter whereby each data unit or byte is in effect allocated a unique numerical identification address corresponding to a unique "location" in the memory system, applying the mapped data (including a time dependent element) to a "node", and storing parameters which define the accumulated mapped data and permit of extraction and reconstitution of the digital data in subsequent "read" operations.

Thus, returning now to Figure 1, each data byte for storage is passed from the MICTR 14 (in practice from the internal data bus 19 accessing to the data buffer register(s) and digital data I/O process stage of which part can be regarded as formed by the bus portion 19a indicated in Figure 1) to the data converter 20 (hereinafter described in more detail), and the voltage analogue output therefrom is then "dynamically compressed" by the logarithmic amplifier 22 which in effect applies a non-linear scaling to the signal before subsequent mapping.

The mapping of the compressed voltage analogue data signals is achieved by modulating them in an analogue summing amplifier 32 of a mapping stage 34 onto voltage analogue base reference signals, obtained from the digital output of the base address counter 24 as hereinafter described, to produce unique "mapped data" voltage analogue signals which, after possible further "dynamic compression" in an optional intermediate logarithmic amplifier 42, are further scaled if necessary in an output operational amplifier 44, herein termed an absolute value amplifier, of the mapping stage 34.

Finally, the unique composite "mapped data" voltage analogue output from the mapping stage 34 is applied through a selective MICTR-controlled switching unit 46 to a respective node 12 wherein the "mapped data" is effectively deposited and stored, in the form of precisely equivalent unique-valued quantities of electrical charge, in an isolated dynamic pseudo-variable precision capacitive element thereof.

Each node 12 can "stack-and-store" several levels of charge corresponding to the successive composite "mapped data" voltage analogue signals received, representing successive bytes of data, each new additional value being summed with the previous accumulated value to build up what may be termed a "charged packet".

As will also be further explained later, in each node 12 the capacitive element is grounded to an adjustable base level potential and in effect has a variable capacitance controlled by the MICTR in accordance with the operative mapping range of the Base Address Counter. Overall, the capacitive element of each node 12 behaves somewhat in the manner of a variable capacitor where it is possible to vary precisely both the capacitive value and the dynamic charge store range (by varying the base level potential or base threshold reference), under the digital control of the MICTR and associated control stages. During deposition of data each node operates in an "integrator circuit" mode. As each byte of "mapped data" is deposited information pertaining thereto is transmitted to the MICTR and is recorded digitly in the latch registers of the parameter store 62. After each batch or file of data input the accumulated charge level is then maintained by continually refreshing in "refresh cycles", again controlled by the MICTR, in a manner analogous to that used for dynamic RAM devices.

Thus it will be appreciated that the "memory" is dynamically operative and at any instant the contents of the registers of the parameter store 62 will reflect in coded form the current charge level and pattern on the nodes 12 which, in turn, represents a package of all the mapped and compressed original data input up to that instant. As indicated the latter can then be reconstituted as required in subsequent "read" operations, basically by extracting the relevant charge values from the nodes in response to input of relevant "read" and "address" signals and carrying out a reverse series of processing operations, under the programmed control of the MICTR.

Upon switching off the unit the overall parameters of the previously stored data, in terms of the node charge levels and patterns, base address values and the last data value entered, remain stored in the non-volatile latch registers of the parameter store 62, so that when the unit is next switched on this enables the nodes to be replenished to their previous levels in a similar manner to that during refresh cycles.

From the above outline description, it will be appreciated that important aspects of this packaging and memory system include the precision and control of the digital/analogue and analogue/digital conversion processes, especially as applied to the data signals, the manner of mapping, derivation of the base reference signals, functioning of the nodes, and organisation of the MICTR in relation thereto.

Some of these aspects and certain stages of the system will now be described in more detail.

## D/A and A/D Data Signal Conversion

It will also be apparent in general terms that the digital-to-analogue conversions involve changing from a digital domain into an analogue domain wherein conventional Boolean logic with only two states, high or low, can no longer be directly applied. Nevertheless, with close control of all the conversion or transformation processes, the system can still be defined and treated mathematically using the concepts and methods of so called "fuzzy logic" and "fuzzy sets" which was first developed and described by L. A. Zadeh in treatises published circa 1965.

In the present system, to help achieve the required accuracy and precision of digital-to-analogue conversions the D/A converters are carefully designed and generally conversion is carried out separately on groups of no more than four bits representing decimal integers up to 9. In addition, the reference voltages supplied to the converters used may be adjustable under the control of the MICTR and accuracy and precision are ensured by sampling the voltage analogue signals generated and using reverse analogue-to-digital conversions in the ADC stage of the data converter 20 to provide again a digital signal of high resolution which is compared within the MICTR with the actual digital input to detect any error and, if necessary, produce a compensating control function to adjust the reference voltage and conversion factor of the relevant DAC sections.

In practice, in checking the analogue signals they are modulated by a variable offset voltage and are sampled under the control of the MICTR to provide a range of signals of slightly different values which are applied to separate multiple inputs of the ADC stage.

The "numerical spectral transform" method utilised in this process of controlling the conversions, involving providing the range of analogue signals, converting into digital with high resolution and comparing with the original digital signal, is under the control of the MICTR in accordance with rigorous mathematical transform algorithms which are micro-coded and form part of the microprogram (advantageously written or coded initially in APL language) stored permanently in the ROM vector of the MICTR memory map space.

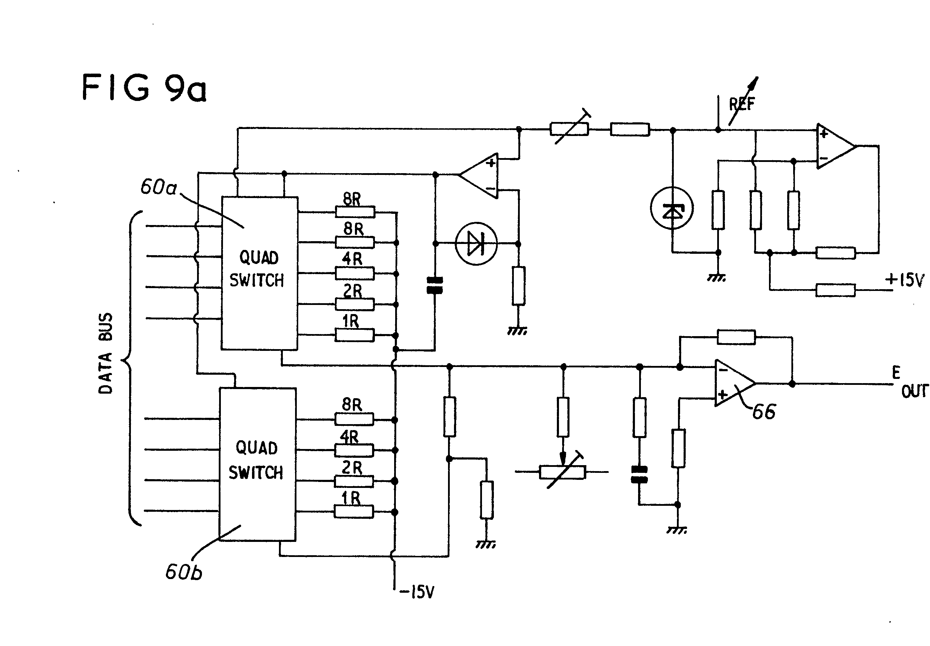

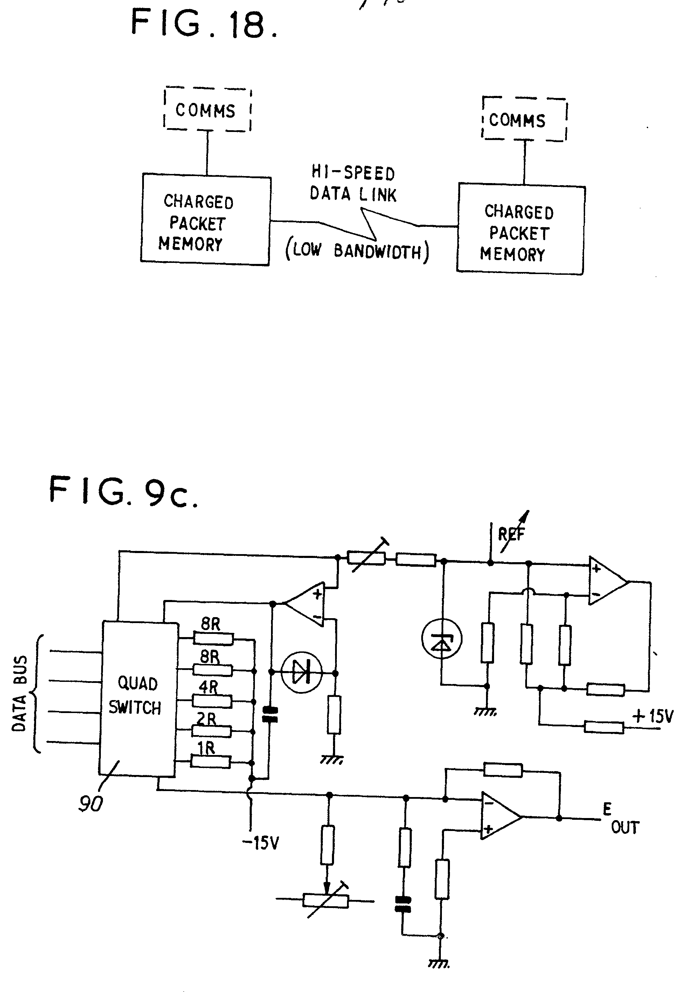

In the data converter 20, the ADC stage serves the entire system, both for checking and for the reconstruction of the data in digital form during "reading" data out, and takes its signals from the analogue bus (see FIGURE 3). The DAC stage, on the other hand, deals primarily with the incoming data bytes and, as shown in FIGURE 9a, may comprise a high precision 8-bit resolution DAC incorporating a stable reference current source and provided with a reference voltage (REF) controllable by the MICTR, together with a pair of so-called quad transistor switches 60a, 60b, such as those available under reference numbers ICL 8018A and ICL 8019A (Intersil), and a ladder-resistor network driving a transconductance amplifier 66 (a current to voltage converter). The circuitry is similar in many respects to that of the COUNT DAC and EXP DAC which are dealt with later.

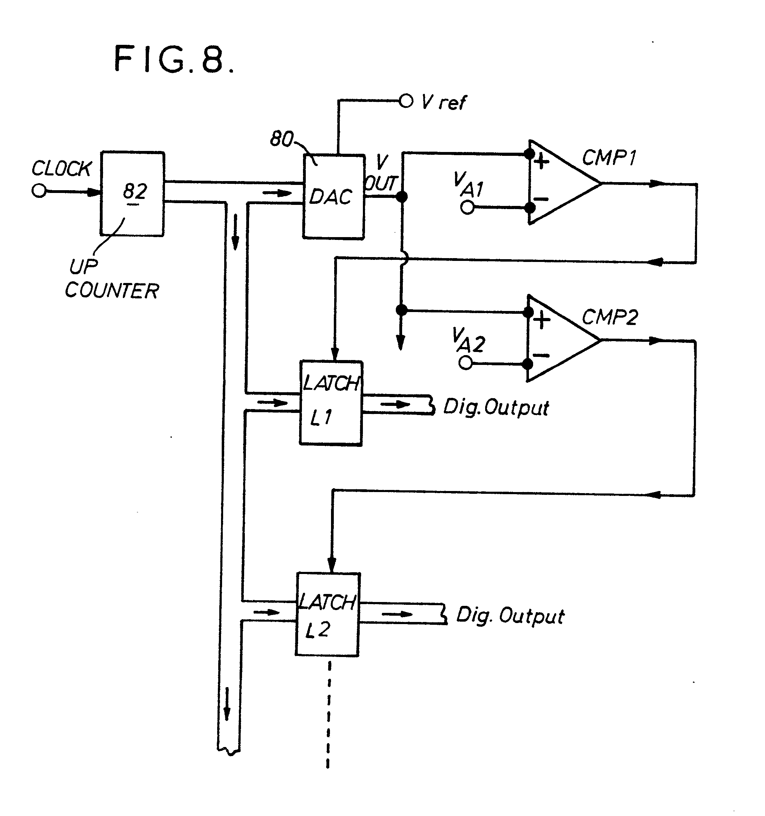

The basic form of the circuit of the ADC section is shown in FIGURE 8 from which it will be seen that a single conventional DAC 80 connected to an adjustable stabilised reference voltage source (controllable by the MICTR) and supplied with a digital input from a clock controlled up-counter 82 drives several independent A/D converters each with a comparator CMP1, CMP2, etc. and corresponding 4-bit latch L1, L2, etc. Each of the latches receives and records the digital input direct from the counter 82 until the DAC output exceeds the analogue input $V_A$ supplied to the respective comparator; at this point the comparator produces an output which operates the latch concerned so that it presents at its output and holds the digital value at which the comparator tripped. The DAC is continuously ramped upwards throughout its entire range so that during this period all the different analogue

inputs $V_{A1}$, $V_{A2}$ etc. to the comparators will trip and set their respective latches which then read out the equivalent digital values.

With this design of multiple analogue-to-digital converter the total number of comparators and latches (and therefore the overall bit-length/resolution) is only limited by the drive capability of the DAC counter. Gain and level shifting applied to the analogue inputs will provide ADC's with different ranges, and also the comparator latch commands can operate "Sample-and-Hold" circuits at the inputs, to signal "data ready", and to inhibit further latching.

## The Base Address Counter and related Analogue Stages

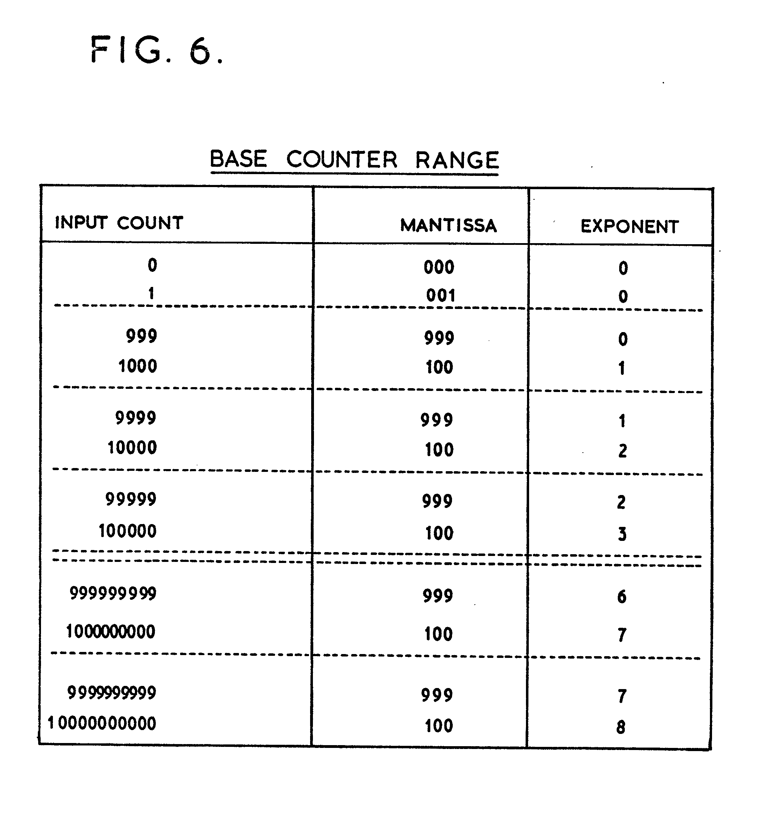

As mentioned, the base address counter 24 has an overall count-up range of at least 0 to 999 x 10$^7$ providing an output in the form of a mantissa ranging up to 999 and a separate exponent (to base 10) as indicated in the Table of Figure 6. Both components are output in binary coded decimal (BCD) digital form. The counter in effect counts the number of bytes input and the set of numbers or addresses generated provides the frame of the base reference address system onto which the individual data bytes are mapped for ordering and identification.

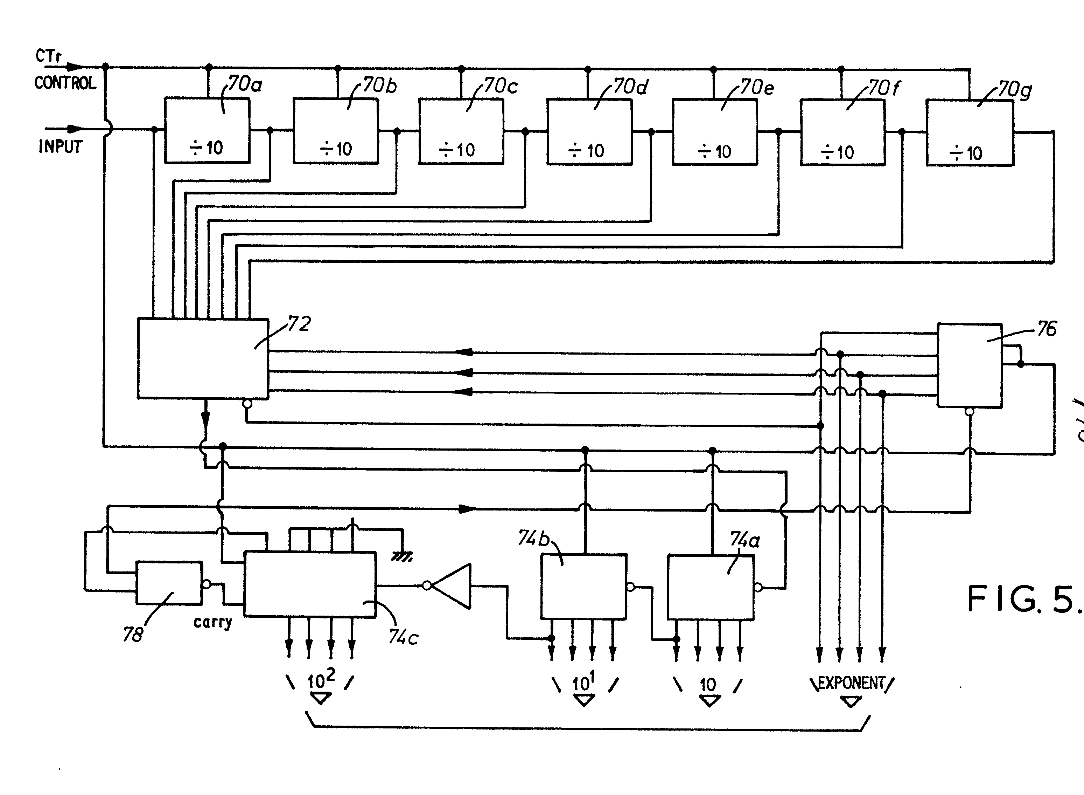

A diagram of a basic base address counter circuit is shown in FIGURE 5. This consists of a set of seven decade counters, 70a to 70g, arranged to provide a seven stage divide-by-ten frequency divider, a multiplexer 72 which selects the "divide ratio" in use, three decade result counters 74a, 74b, 74c which respectively provide the BCD output for the three digit components of the mantissa, and a binary exponent counter 76 driven through a latch 78 from the "carry" output of the most significant bit (MSB) decade result counter. The BCD output of the exponent counter on the three output lines for the exponent count counter also provides the addressing signal to the multiplexer, and a fourth output line is used to carry a "count overflow" bit indicator. The latter is also connected to the multiplexer, to a "disable" input thereof.

This circuit stage counts gated input trigger pulses derived from a control logic stage which effectively issues a trigger pulse each time a data byte is "written into" the memory system. Each successive input trigger pulse, and thus each data byte "written in", increments the base address counter by one.

It will be seen that for each exponent value an output of only three significant digits (decimal) can be provided by the result counters 74a, 74b, 74c, for the mantissa component so that not every number within the overall range can be output directly.

Thus, in operation, starting from a true count of zero counting will proceed normally, with the multiplexer 72 set to the first input line taking the input trigger pulses directly, until a count of 999 is reached which is output by the result counters, the exponent counter remaining set at "zero" output. On the next input pulse, the "units" and "tens" result counters reset to zero while the "hundreds" result counter 74c resets to 100 (decimal) and also outputs a "carry" bit to the exponent counter 74 which increments to one (decimal). The changed output of the exponent counter is presented (in BCD) on its output lines and also resets the multiplexer 72 to select the second input line from the output of the first stage decade counter 74a in the frequency divider chain. For subsequent input trigger pulses, therefore, only every tenth one is counted and registered by the result counters until ten thousand is reached, at which stage the result counters are again reset, the exponent counter is incremented to 2 (decimal) and the multiplexer is reset to select the third input line from the output of the second stage decade counter in the frequency divider chain and then every hundredth input pulse is counted. This process is repeated at every further ten-fold multiple, and the form of the output throughout the count-up range up to $999 \times 10^{7}$ is as indicated in the Table of FIGURE 6.

It will be apparent that this arrangement in effect divides the overall counter range into eight sub-ranges or "levels" which are a feature of this system, and in order to be able effectively to provide a unique identification address for each incoming data byte in the upper levels a technique is introduced of modifying the exponent output value by subjecting it to a precisely controlled time based variable scaling before the mapping combination with the voltage analogue signal equivalent of that respective data byte.

For the mapping with the data byte voltage analogue signals, the digital output of the base address counter is also converted with high precision into equivalent voltage analogue form. First, the BCD mantissa component is converted to its "nines complement" (in the MICTR) and is then output on a 12 line bus 26 to a digital-to-analogue converter (count DAC) 28. The BCD exponent component, similarly also converted into its "nines complement", is output on 3 lines of a four line bus 36 to a further digital-to-analogue converter (EXP DAC) 38.

The digital output of the base address counter 24 is also held in the MICTR 14 for other processing and storage of parameters relating thereto, and in particular the mantissa component is combined with the digital value of the corresponding respective data byte input (extracted from the data input register) by, in effect, subtracting the data byte digital value from the nine's complement of the mantissa component to provide a further mapped reference quantity which is entered in the parameter register store 62 and, inter alia, can be utilised in a test loop routine of the programmed operation of the MICTR for checking and interpreting the data and analogue values.

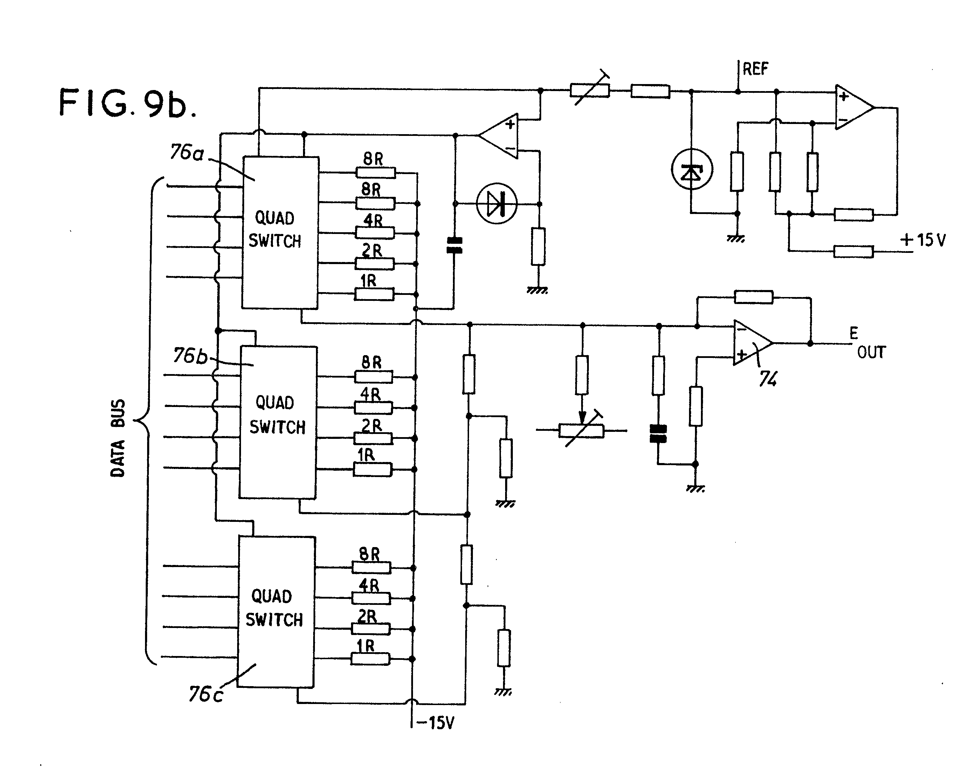

The COUNT DAC 28 is a high precision 12-bit converter of which a circuit diagram is shown in FIGURE 9b. A voltage analogue output is obtained by a current-to-voltage transconductance operational amplifier 74 in the final stage from an analogue output current derived from the sum of the currents from the three so-called "quad" 4-bit transistor switching units 76a, 76b, 76c which may be monolithic integrated circuit elements such as those available under the references ICL8018A/ICL8019A/8020A (Intersil). A stable value for the collector current of the reference transistor within the quad switch integrated circuit is provided by using a high gain operational amplifier to compare this collector current against a reference current generated in a resistor network by a temperature compensated zener diode stabilised using an operational amplifier regulated supply.

The voltage analogue output from the COUNT DAC 28 is subsequently compressed by passing through a logarithmic amplifier stage 30 before feeding to the summing amplifier 32 to provide one component of the base reference mapping analogue.

The EXP DAC 38 is similar to the count DAC 28 except that it utilises only one quad switching stage 90 to deal with the BCD exponent output on the 4-line bus from the counter (3 lines for the 0 to 7 exponent range and the fourth line for the Base Count overflow bit).

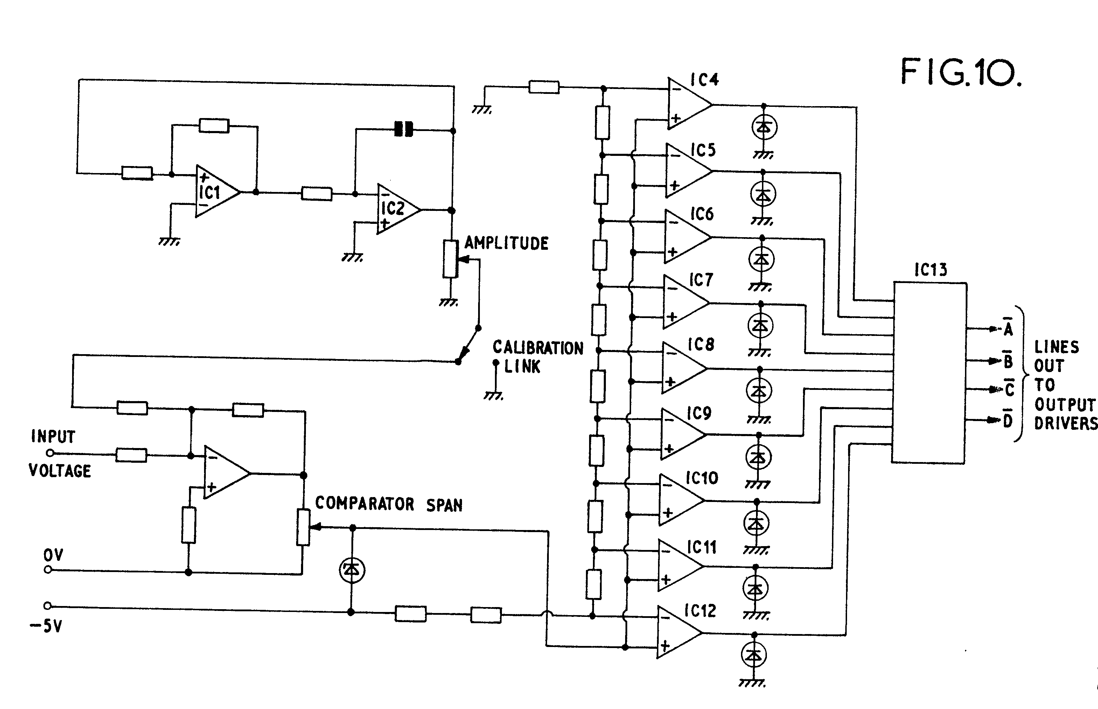

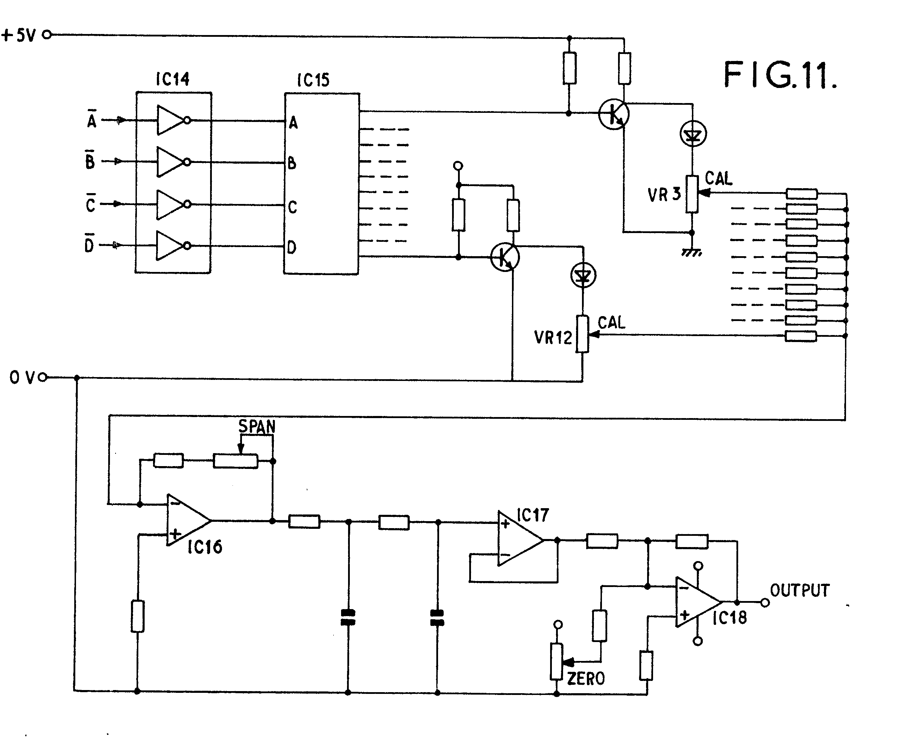

The voltage analogue output of the EXP DAC is then passed to a time-based analogue function generator 40 of which the circuitry is shown in FIGURES 10 and 11, FIGURE 10 being an input stage and FIGURE 11 being an output stage.

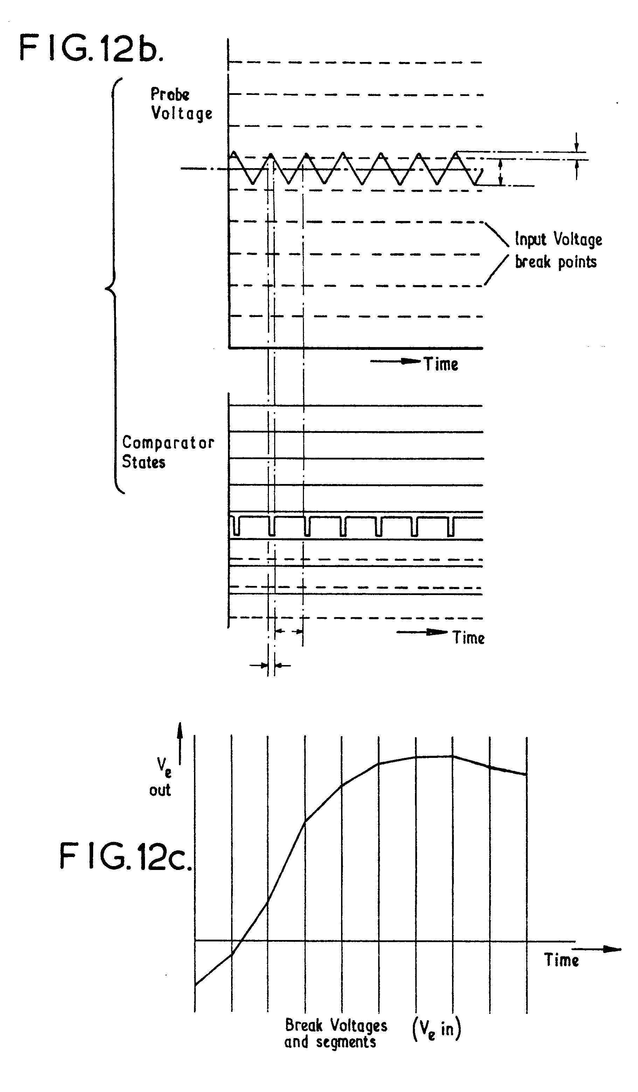

In effect, this analogue function generator 40 provides a voltage analogue output which is related to the voltage analogue input, over a predetermined range of the latter, by a precisely controllable or programmable variable functional relationship or characteristic curve, as shown for example in FIGURE 12c, the control being exercised through the MICTR, and enables a controllable time-dependent relationship and mapping.

Since the value of the voltage analogue input ($V_e$) depends on the number of bytes and changes with every level of the base counter reached through the exponent range 0 to 7 (complemented values 9 to 2), it is also a time dependent quantity, as indicated schematically in the diagram of FIGURE 12a, and by means of the analogue function generator stage the stepped form of graph of the latter can be converted into a smoother time dependent relationship as illustrated in FIGURE 12c.

To explain the operational principle of the circuit, the predetermined range of the input (the voltage analogue from the EXP DAC 38) is considered to be sub-divided into nine sub-ranges by defining ten "break voltages" which are nominally equally spaced throughout the input range. In the input stage (FIGURE 10) of the circuit, a coarse measurement of the analogue input voltage, determining the relevant sub-range in which it falls, is achieved by applying the input voltage in effect to a series of voltage sensitive switches which "close" at the different "break voltage" levels equally spaced throughout the input voltage signal range, and a fine measurement is achieved as will be explained by superimposing on the input voltage signal a periodic second "probe" voltage signal having a symmetrical triangular waveform and an amplitude exactly equal to the difference in adjacent levels of the "voltage sensitive switches". This triangular waveform signal, for a given input voltage signal which is steady for the measurement period being considered, thus causes the voltage sensitive switch for the nearest "break voltage" level, and the voltage sensitive switch for the next lower level, to switch on and off alternately so that they each produce pulse signals having particular values of mark-to-space ratio (m.t.s.r.) according to the actual value of the input voltage signal in the sub-range concerned. The relative percentage values of the m.t.s.r. of the output of the "switch" of the two adjacent "break voltage" levels, measurable by averaging the pulse signals in a CR network of suitable time constant, then gives a precise measure of the input voltage signal in terms of its value within the particular sub-range of the predetermined overall range.

Interpolation between adjacent "break voltage" levels by reference to averaged m.t.s.r. values is a feature of this analogue generator.

Referring now to FIGURE 10, the "voltage sensitive switches" are provided by a string of nine comparators, IC4 to IC12 inclusive, set to "trip" (change state) at equally spaced successively increased voltage levels. The input analogue voltage is linearly scaled by a scaling amplifier IC3 and is applied to the non-inverting input of the comparators IC4 to IC12. Upon scaling such that the overall range of the analogue voltage input is divided into nine equal intervals represented by ten "break voltages" of 0, 1, 2, 3, .... 9, then the comparators IC4 to IC12 will be set to trip respectively at these levels.

The additional switching triangular waveform for the m.t.s.r. or time averaging interpolation technique is provided by the probe waveform generator section which includes the amplifiers IC1 and IC2, and this waveform is added to the voltage analogue input at the scaling amplifier (IC3) stage. The effect of this probe waveform is further illustrated in the diagram of FIGURE 12b.

As will be seen, the direct output of each comparator IC4 to IC12 in the circuit of FIGURE 10 is passed, along diode protected lines, into an encoder IC13 which provides an inverted BCD digital output embodying, by its value and periodic variation, the information about the input signal and this digital output is applied to drive the output stage of the analogue function generator shown in FIGURE 11.

Basically, after inversion in an invertor IC14, each BCD state fed into this output stage is caused, through a decoder switching unit IC15, to switch "on" a respective one of ten voltage levels all of which are pre-set by calibration potentiometers VR3 to VR12. Successive voltage levels thus switched "on" (still reflecting the m.t.s.r. of the output from the input stage of FIGURE 10) are then summed through a summing amplifier IC16 and passed through a second order RC filter which finally averages the signals before being output through a buffer amplifier IC17 and adjustable scaling output amplifier IC18.

It will be seen that the magnitude of the original voltage analogue input effectively determines which voltages are switched "on" and "off" and what m.t.s.r. is applied to these switched voltages in this output stage. However, the magnitude of each of the switched voltages, and therefore the way in which the average of the voltages changes as the m.t.s.r. of each varies, is dependent on the setting of the calibration potentiometers and this determines the actual shape (after scaling) of the nine segment function characteristic curve (FIGURE 12) generated. Since each of the switched voltages are independently adjustable so are the levels of the break-points in the characteristic curve, while each segment of the curve joins smoothly with adjacent segments. This gives great versatility and enables almost any characteristic curve for an input/output function, capable of being approximated by a nine-segment "straight line" fit method, to be produced.

The so-called calibration potentiometers VR3 - VR12 in this function generator are in fact digitly controlled variable resistors and are controlled by the MICTR. By this circuit and effectively adding an "offset" value to the exponent voltage analogue it is possible to allot a unique address voltage analogue value for each byte in the higher "count" levels and maintain identification thereof.

The Nodes and Data Deposition

As already mentioned, the nodes 12 each include a capacitive element which exhibits characteristics of a variable capacitor under digital control by the MiCTR.

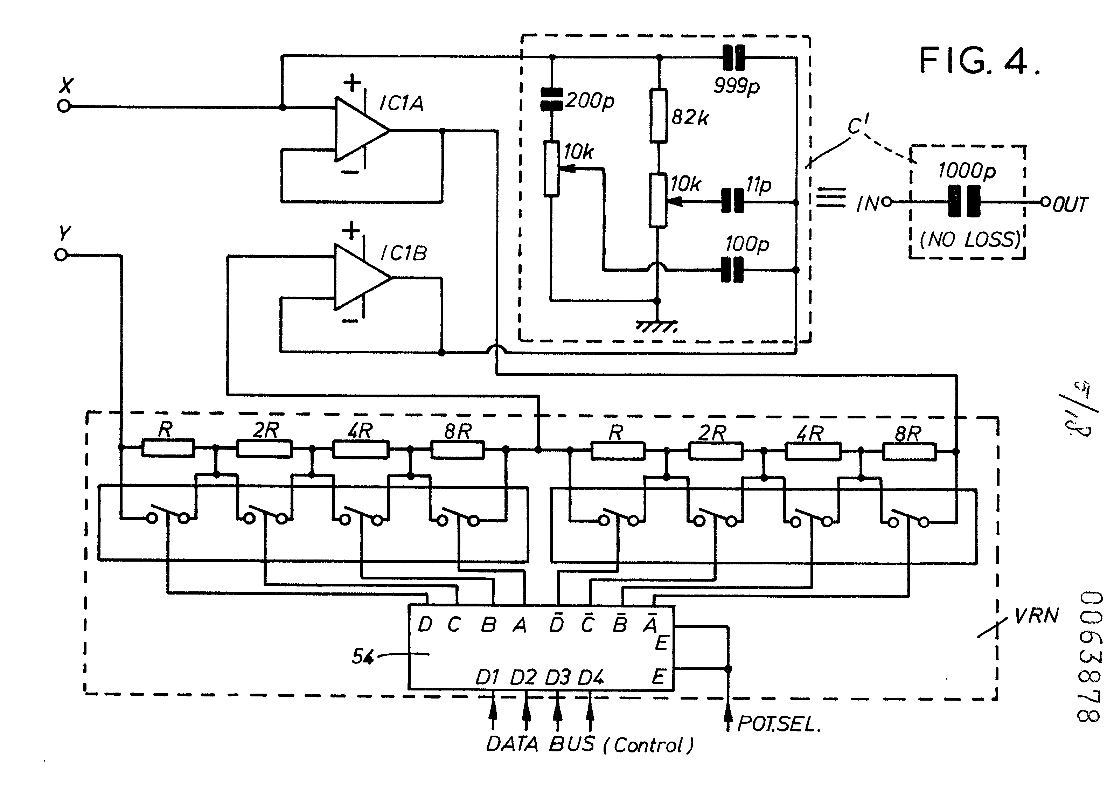

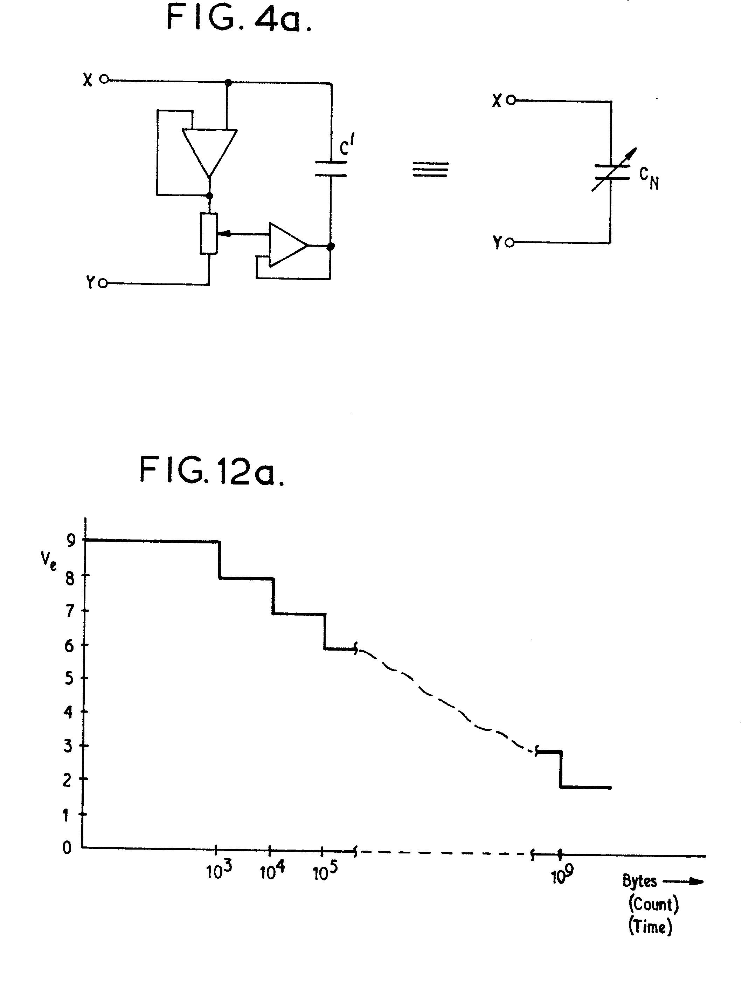

A schematic simplified diagram of the basic circuit of the pseudo variable capacitive element stage of a single node is shown in FIGURE 4 from which it will be seen that it comprises a capacitive element $C'$, provided by a passive network of high grade capacitors and resistors, which is electronically adjustable through a digital switch controlled variable resistor or potentiometer, generally designated VRN, and a pair of operational amplifiers IC1A and IC1B connected as voltage followers. The digital switch controlling the potentiometer VRN is a 4-bit latch 54 which receives its control signals through part of the internal data bus 19 of the system and an enable signal through a "Pot. Sel." line from the MICTR.

A simplified explanation of this circuit is as follows. If it be assumed that a voltage $V_i$ be applied to the input terminal X, this voltage appears at the output of IC1A and is attentuated by the potentiometer VRN to a reduced value $kV_i$ which is then applied through IC1B to one "pole" of the capacitive element $C'$. This element $C'$ has its opposite "pole" connected directly to the input so that the potential difference across it is $(1-k) V_i$ and the effective capacitance "seen" by the input between terminals X and Y is $C'(1-k) V_i$, k being a variable fraction set by VRN. The effective capacitance can thus be varied from practically zero to the full value $C'$. This stage of the node can thus be regarded as being a variable capacitor $C_N$ as indicated in the equivalent circuit diagrams of FIGURE 4a.

In practice, the operational amplifiers, IC1A and IC1B must have extremely high input resistance and may be implemented by a dual FET input operational amplifier 16-pin IC package such as that available under a type reference number ICL 8043.

Also, the requirements for C' are very critical because theoretically a "perfect" capacitor with no loss and high stability characteristics is required. Thus, in the passive network shown, which represents an equivalent capacitive element C' of 1000 pf, all the capacitors are precision silvered mica and the complete element is oven mounted and factory calibrated to give an element with a stability of the order of 1 part in one million and a residual phase angle difference from pure capacitance of one micro-radian.

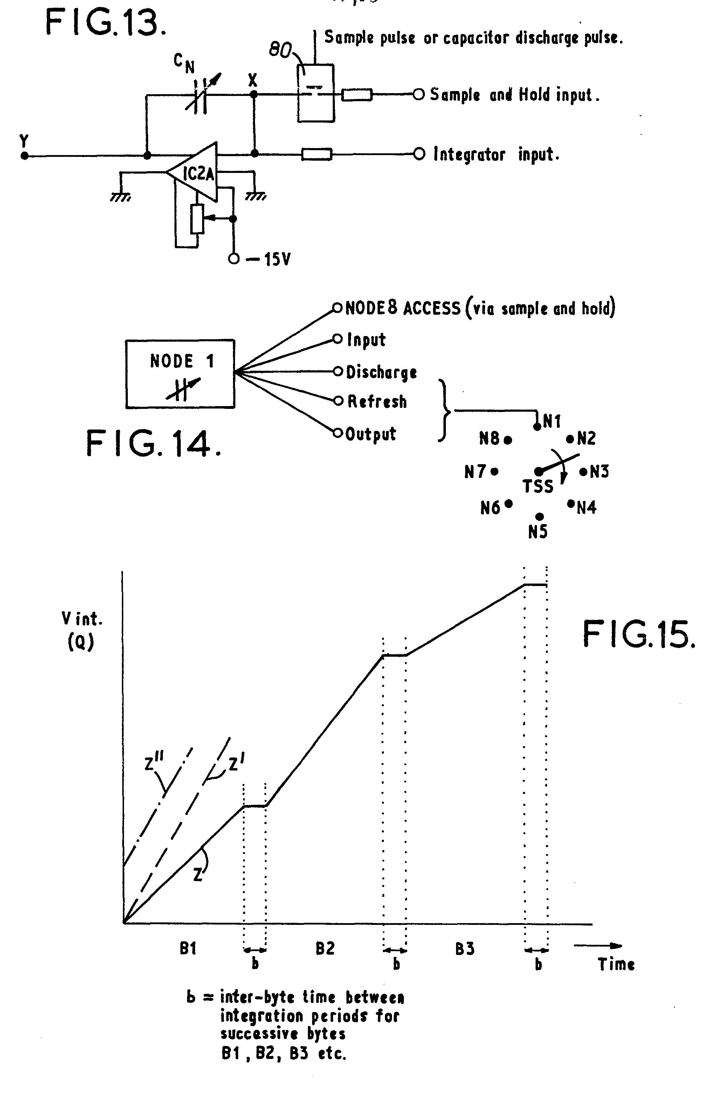

In each node, the pseudo variable capacitive element stage of FIGURE 4 is connected across an operational amplifier, as shown at IC2A in the schematic diagram of FIGURE 13, so as to provide an operational integrator circuit, and it is by acting as an integrator that charge from an incoming data voltage analogue signal is deposited on the capacitive element. As indicated, however, the circuit is also arranged to operate in an alternative "sample and hold" mode selected by a switching circuit 80, the particular mode of operation again being under the control of the MICTR.

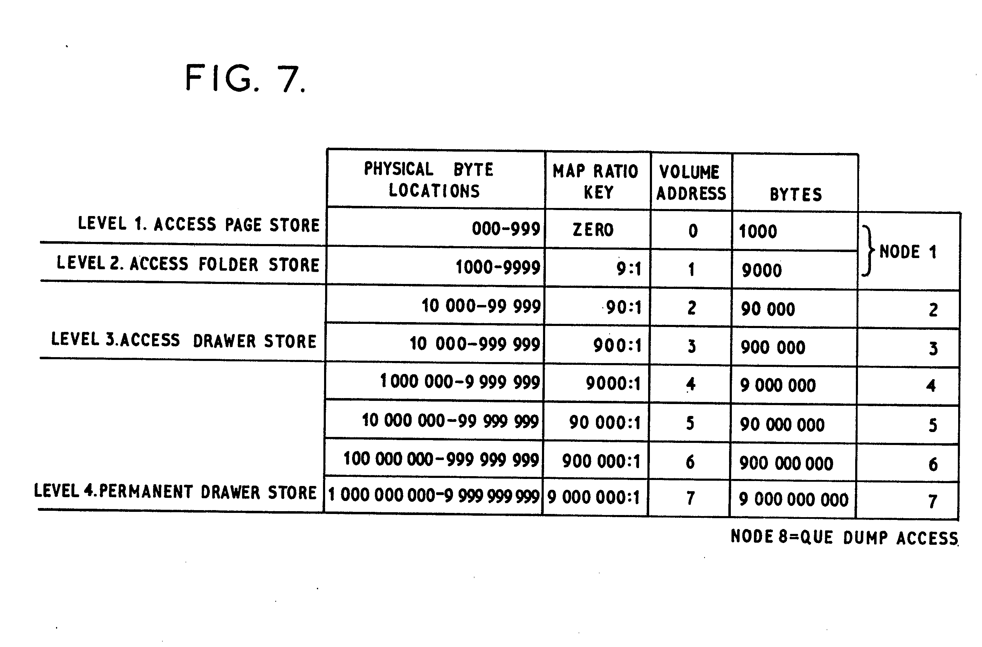

The number of nodes 12 provided will depend upon the storage range and access speeds required, but in the present example there are eight nodes and a capacity of approximately 9.9 gigabytes of digital data may be achieved in accordance with the data storage structure indicated by FIGURE 7.

In this arrangement, NODES 1 to 7 are used for the storage of the mapped data but NODE 8 is used as a temporary store for extracting data and for other purposes as will be subsequently more fully explained.

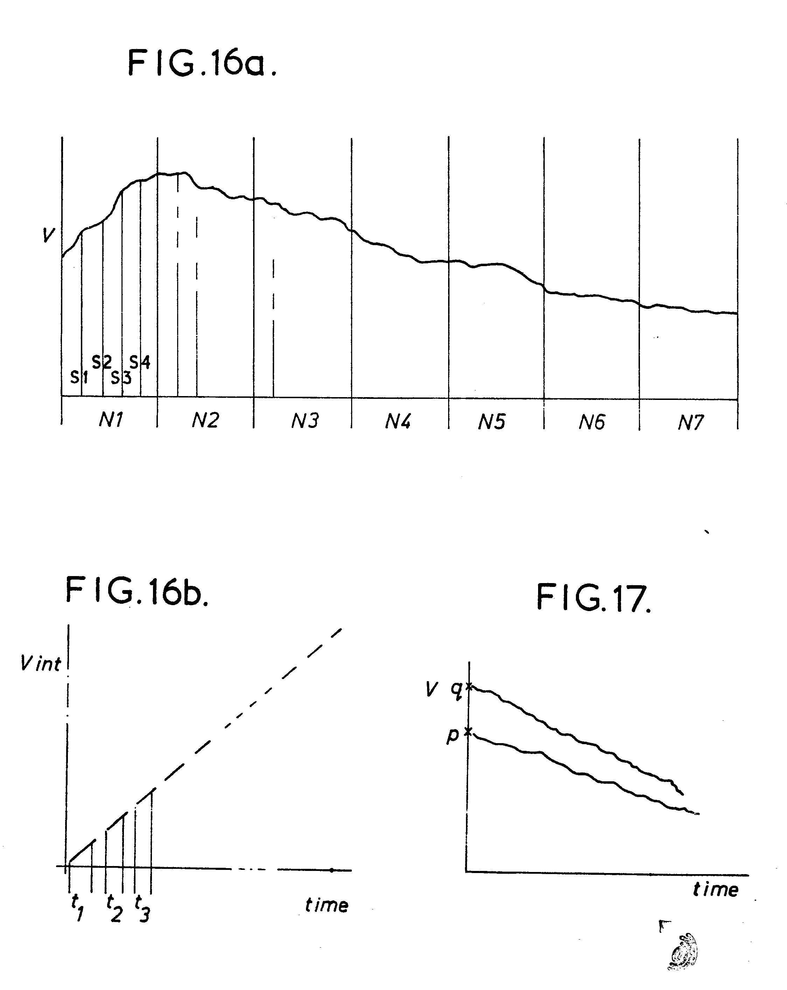

When a mapped data analogue signal is applied to a node, as indicated above the node is in an "integrator mode" and the integration voltage or potential $V_{int}$ representing the charge level (O) ramps upwards for a predetermined time (integration period), set by the MICTR programmed control. This process, relative to a base voltage reference level, for several successive mapped data signals derived from successive bytes B1, B2, B3 etc. is shown in a somewhat exaggerated form by the graph z in FIGURE 15. Thus, the charge level after deposition of each byte of mapped data provides the base level for the next on that particular node.

It will be understood that for a given input signal voltage the slope of the graph z is dependent on the value of the capacitor $C_N$ and thus on the setting of the digital potentiometer VRN. The latter in effect varies the characteristic integration value and provides a time scaling control, enabling the slope of the ramp to be altered as indicated at z'. Voltage scaling can also be introduced by altering the base reference voltage level, as indicated at z''. The time scaling control in particular helps to accommodate within reasonable output voltage levels a wide range of compression of the mapped data signals characterised by a range of different integration periods or sampling times, but also provides a time dependent mapping reference within the system. As will be seen from the Table in FIGURE 7, very high degrees of compression are required on the higher nodes, and the integration periods will be altered accordingly with a different value for each node and appropriate scaling will be applied as mentioned above.

In general, with a sequential storage of data input the data bytes will be mapped and applied to the respective nodes in accordance with the distribution shown in FIGURE 7 which is programmed in the MICTR.

Input and output connections to the nodes may be regarded as being established through the switching unit stage 46 indicated in FIGURE 1, but it will be appreciated that this includes numerous different programmed dynamic switching functions needed in the various cycles of operations. A typical set of input or output

0063878

paths, for example for NODE 1, is shown very schematically in the diagram of FIGURE 14 which also shows that some of these paths are routed via cyclic switching stages, such as that labelled TSS, which feed in sequence to different nodes in a programmed time scan period analogous to cyclic switching stages in time division multiplex communications systems.

A cyclic switching stage of this kind will for example be used in the "refresh path" so that all nodes can be regularly refreshed, after all the input data has been stored, by associated refresh circuitry programmed through the MICTR in accordance with information from the stored parameters relating to the last recorded charge level of each node concerned.

## File input and processing

Returning now, however, in more detail to an example of the general operation of writing in data as previously indicated this will be organised as a file identified by a particular "file name" held in a 12-byte vector in the Host RAM space (see FIGURE 2).

At the commencement of a write-operation, following a preliminary signal on the FC1 line which initiates some basic "housekeeping" operations by the MICTR, the "file name" bytes or a selected part thereof are transferred to the MICTR RAM space. They are therefore mapped to the initial address of the base address counter and, including a count of several byte times introducing a "time dimension", the mapped "file name" is processed as described for data and the corresponding analogue is deposited on a node utilising a distinctive integration constant significantly different to that utilised for later depositing mapped data within the file. The aim is to provide thereby a distinctive "time key" which can be recognised as a "file name" when subsequently extracting data. Also, the composite digital value of the "file name" bytes mapped will be chosen so as to lie outside the range (0 to 255) of data bytes in the system.

As also previously mentioned, the data is transferred and processed in blocks. In this example, as indicated in FIGURE 3, the "input source or data buffer" in the MICTR RAM has a capacity of 16K bytes which represents the maximum size of block which will be processed at any one stage. With large files, further blocks will be dealt with sequentially.

When a data block is transferred into the data buffer, before proceeding with processing and storage, the bytes therein are first checked by the microprocessor through a suitable algorithm to detect any values or strings likely to cause difficulty or ambiguity in mapping to the complemented base address counter values. Thus, certain combinations of addresses and data values could result in the same digital mapped data value. For example, a first byte value of 02 mapped subtractively to a base address value would give the same mapped value as a next byte of value 01 bearing in mind that the base address counter increments (complement decrements) by one for each byte. Also, once a data byte of one particular value has been received and stored a method needs to be introduced so that it is unnecessary to store that same value again independently for any subsequent byte.

In practice, the range (0 to 255) of digital byte values are held in one or more "look-up" tables in the parameter register, and upon storing the digital mapped data values as reference values in main memory pointers are set to indicate the actual data values in a respective "look-up" table. In the case of a plurality of bytes having the same value after the first entry, for each subsequent one the relevant main memory address for holding the digital mapped value may be filled with the digital mapped value of the first entry together with a marker to make it unique indicating that the address content represents only a pointer. This marker, like the "file name", may through the programmed control also be linked to a distinctive integration value when the relevant analogue mapped equivalent of this byte is deposited on a node whereby it can be identified when being extracted.

In some cases, the fact that the above routine for handling bytes of identical value results in the mapped values of these bytes (after the first) not being specifically entered releases these values, which may be termed "key values", for possible use in mapping other data values whose normal mapped value would duplicate another thereby avoiding this difficulty. In other cases of conflict producing duplicate mapped data values, however, the microprocessor may be programmed to arrange for another different kind of mapping to be performed; or in further cases of difficulty methods of bit redundancy and discarding certain values may have to be adopted which can be handled by suitable algorithms.

Use of such "key values" or other special technique may again be linked to a distinctive integration value when depositing the corresponding analogue mapped value, and it will be appreciated that this technique of introducing distinctive integration values for particular data bytes which would otherwise cause mapping problems represents a further way of introducing and mapping in respect of a time domain.

After the preliminary checking of the bytes of the data block in the data buffer and organising any necessary remedial action to meet any problems predicted as referred to above, the MICTR will initiate the main processing and storage of the data block with each byte in turn being converted into the corresponding voltage analgoue and being mapped on to the analogue base address reference derived as previously described, followed by depositing the mapped analogue value on a selected node.

At the end of depositing the last byte of the block, marked by the end of the integration period thereof, the capacitive element of the working node concerned then carries a packet of charge representing the total of all the mapped data bytes in the block accumulated in a known number of known time intervals, together with the file name mapped below on top of any previously stored data. The other nodes will also carry some charge since even if they do not contain any mapped data they are initially brought up to a certain base charge level.

The next step is to sample the charge level or voltage built up on the working node and the analogue sample is digitised and passed back to the MICTR for storing in the parameter register store 62. Digitisation of this sample is achieved by feeding it back (via the data return path designated 50 in FIGURE 1) to the A/D converter stage of the data converter 20 which serves the whole system.

To obtain the further data required for storage, and in particular all the parameters required for permanent storage for reconstituting the charge pattern on the nodes, a scanning operation is then carried out to derive a function defined by storable parameters representing this charge pattern within the time domain.

In carrying out the scanning operation, first the charge level on the working node may be sampled and copied on to Node 8. This is then discharged for a set time during which voltage analogue signals are taken at clocked intervals via a sample and hold circuit and are digitised and passed to the MICTR for storage.

The same operation is then likewise carried out in turn for each of the other nodes to complete a first scan.

A second similar scan is then carried out using a different rate of clocked intervals for sampling the discharges, and these operations are again repeated several times, the scanning cycles being controlled by a loop algorithm.

The values of the sampled voltage analogue signals thus obtained during each of the discharge periods represent coefficients of the required function taken along "slices" of the latter which is three dimensional in form. An illustration of this is shown in the diagram of FIGURE 16a which is a section through the "slices" mentioned and some of these are labelled S1, S2, S3 etc. for consecutive scans of nodes N1 to N7.

The timing intervals between successive scans is relatively long compared to the integration times of the nodes and hence the coefficients obtained from these scans give only a rather coarse picture of the function.

To obtain greater resolution and obtain further parameters, the following procedure is adopted. First, to work on node 1 this is again copied to node 8 and then node 1 is flushed i.e.

completely discharged. A voltage analogue signal corresponding to the last mapped data on that node (known from the parameters already stored) is then applied to the empty node 1 for a time equal to a first time period $t_1$ and at the end of this period the integrator voltage is sampled, digitised, and stored.

This is then repeated for further time periods $t_2$, $t_3$ etc. until the total integration time of the last mapped data has been reached, as indicated in FIGURE 16b, and by simple arithmetic operations a value for charge built in the total integration time can be obtained to provide further co-efficients in the nodal function.

Afterwards a refresh cycle may be performed before the next block recycling via Node 8 which will incidentally bring the "file name" to the top of the node.

## Data Extraction

To read from the memory it is necessary to try to reconstitute the charge level on the relevant node at the address of each data unit required, working sequentially through the file concerned; and the programmed processing depends on the parameters stored.

Although the complete process and algorithms are complex a brief outline of a typical "read" operation in respect of a stored file is given below.

Initially, the relevant "file name" will be sent by the host to the memory module and from this identification the MICTR will recognise which of the seven nodes would hold the file and can further estimate, using a software prediction algorithm, a position or level within the node at which the "file name" marking the commencement of the file is likely to lie. This estimate is made in terms of a number of clocking time intervals below the top level of the last stored mapped data.

It may be recalled at this stage that, inter alia, the MICTR holds the stored digital values of the last stored data byte and address together with the mapped data value. These values are stored per node. Also, the stored, mapped "file name" contains a characteristic File Key, provided by the distinctive value allotted outside the range of normal data values and also a "Time Key" provided by the distinctive integration period used when it was stored on the node, and these "Key values" are also held in store.

First, the charge level on the working node concerned is copied on to Node 8 and charge is taken off quickly in a discharge cycle against a clocked count to bring it to the estimated position of the mapped "file name". At the level reached, the charge is sampled and the voltage analogue is fed back, digitised and passed to the MICTR. On then taking off the next charge in a controlled discharge period matched to the "Time Key" integration period, a further sample is taken, digitised and compared with the previous. The difference should yield the digital mapped value and is compared with the File Key value to confirm. If it is not correct and the position has been misjudged, a further copy of the working node can be copied on to node 8 and a further trial carried out. Thus, a search may be continued in the same region of the node until the "file name" is located.

The start of the file has now been reached and the subsequent mapped data units must be taken off and the data values separated from the base address. At this stage the present base address is known. A discharge cycle is then carried out mapped to the relevant integration period for that file and node, and the next level is sampled and digitised to obtain the mapped data value taken off. By difference with the known address, the data value is found.

This data value needs to be checked, however, to ensure that no errors have arisen in tracking or otherwise. In one checking routine, the digital value derived may be passed through the system again, transformed into analogue and put back on the node (NODE 8), followed by a fresh discharge scan, as shown as q in FIGURE 17. A second digital value differing by one may then be derived by decrementing in RAM and this is placed on the node to obtain another discharge scan indicated at p in FIGURE 17. By this repeated operation with the dynamic functioning of the system and applying predictive algorithms, a reliable and accurate true data value can be confirmed.

This process is then repeated level by level through the node keeping a running count, until the end of the file is reached.

It will be appreciated that the non-volatile parameter register store has a very large information capacity with the arrangement of 256 x 32 bit registers since the bits can be read in many different arrangements of selected groups and the same
information may be read in different ways. A major factor in the
enormous potential capacity of this system, however, is believed to
be the introduction of the time domain as a versatile mapping base,
and this is also applicable to the parameter store in that in
considering groups of bits, individual members can change value
within opposite ends of software timing loops so that time becomes
an additional dimension in relation to the information capacity of
the system, and mathematical methods of "fuzzy logic" and "fuzzy
sets" are applicable.

With this radically different approach, it is possible to
achieve exceptional degrees of compression. It may be noted,
however, that the information for setting up and reconstituting the
charge patterns on the nodes is largely contained in the stored
coefficients of the nodal function which has characteristics of
three-dimensional modelling with two time domains and the essential
parameters can be contained in a relatively small area of working
memory, and this gives considerable scope for packet transmission
of data between intercommunicating units.

As seen, the parameters maintained via the MICTR and stored in the parameter register store 62 are used in connection with the continual recycling and refreshing of the stored data held on the nodes as mentioned above, and also in connection with (i) effecting precise control of data input and output during read/write cycles, (ii) replenishing the nodes at "cold start" after the unit has been switched off (this may be achieved within 25 ms for 9.9 gigabytes storage), and (iii) extracting data in a "read" operation and in connection with the "Transform" phase by the MICTR (permitting a data access time in the range of 200 – 300 nanoseconds to be achieved in this example).

A charged packet memory device such as described thus provides non-volatile very high density memory storage for digital data which is suitable for use in any general purpose microcomputer, mini-computer or other data acquisition system. As mentioned, the device described can provide a total storage density of 9.9 gigabytes of digital data which is transformed to analogue form, dynamically compressed and mapped at high precision into the "node" storage units using a "Base Address Counter" as the mapping reference in a range of 0 to $999 \times 10^7$. The memory module storage range can, however, be readily expanded further such as to yield, for example, a byte storage range of 0 to $999 \times 10^{15}$.

Features and advantages of the design employed include:

a)  Very low power consumption compared to normal solid-state storage mediums, being typically of the order 2.5 to 3 AMPS in the worst case.

b)  The module is totally solid-state and of small physical size, and interfacing into existing computer systems requires no modifications to the system circuitry.

c)  Random access possible and high access speed, typically of the order 200 – 300 nS.

d)  Extremely low production costs in comparison to existing storage units of less density range.

e) Impervious to high magnetic fields, charges and radiation. The module has a very stable temperature coefficient operating range under extreme environmental charges.

f) Impervious to high vibration ahd shock-forces.

Used in general digital and computer technology applications, charged packet memory devices of the form described should more than adequately meet the normal requirements of high-speed high-accuracy bulk buffer storage and can provide significant advantages over conventional non-solid state mass data buffer storage systems such as magnetic tape, card or disc.

Having regard to the inherent accuracy and high precision control, charged packet memory devices as described can also be used interconnected in pairs in communications systems providing high-density, high-speed and low-bandwidth data transmission networks, as indicated in the diagram of FIGURE 18. Thus, in this arrangement the entire charged packet representing the whole stored contents of one memory module or .device can be output or "down loaded" in block form over a low bandwidth transmission line data link direct to a remotely located second memory module or device.

CLAIMS

1.   A method of processing and packaging digital data
comprising converting the data bytes into electrical
analogue quantities, combining such data analogue quantity with
a further electrical analogue quantity representing a unique
numerical identification address to be allocated to the
respective data unit or byte thereby to produce a unique
composite "mapped data" electrical analogue, such further
electrical analogue quantity being derived from a digital
counter and providing a base reference for mapping the input
data, transferring such composite "mapped data" to a storage
unit wherein it is deposited in the form of a precisely
equivalent unique value of electrical charge on an isolated
capacitive element thereof, whereby successive composite "mapped
data" electrical analogues representing successive mapped data
units or bytes sequentially deposit equivalent electrical
charges and build up a charged packet in the storage unit which
is accessible so that the constituent unique charge values can
subsequently be extracted and analysed back into the
corresponding digital data such as to permit "reading" from any
selected location, all operations being under the overall
supervision of programmed  central processing means.

2.   A method as claimed in Claim 1, wherein the mappings of
the data are carried out in time domains and reconstitution
of stored data is carried with reference to stored digital
parameters.

3.   Apparatus for carrying out the method claimed in any of
the preceding claims.

FIG. 1.

## FIG. 2.

| | HOST RAM SPACE | |
|---|---|---|
| LOC 1000 | FE=READ    FF=WRITE | BASE ADDRESS & MODE-OP CODE VECTOR |
| 1001 | START ADDRESS BLOCK MSB | } START ADDRESS OF DATA BLOCK IN HOST |
| 1002 | START ADDRESS BLOCK LSB | } MEMORY(READ FROM/WRITE TO) |
| 1003 | END ADDRESS BLOCK MSB | } END ADDRESS OF DATA BLOCK IN HOST |
| 1004 | END ADDRESS BLOCK LSB | } MEMORY(READ FROM/WRITE TO) |
| 1005 | STORE ACCESS LEVEL MARKER | LEVEL 1 TO 4:=01.02.03 & 04 |
| 1006 | STORE FILER/SORT MODE MARKER | OP-CODE DETERMINES FILE SEQUENCE IN STORE |
| 1007 | FILE DATA ERROR FLAG #1 | |
| 1008 | STORE DATA/SORT MODE MARKER | OP-CODE DETERMINES DATA SEQUENCE IN FILE |
| 1009 | FILE DATA ERROR FLAG #2 | |
| 100A | PERIOD(.) OR HEX00 [*REFERS] | |
| 100B | F | |
| 100C | I | |
| 100D | L | |
| 100E | E | 12 BYTE "FILE NAME" VECTOR |
| 100F | N | |
| 1010 | A | <.FILE NAME> |
| 1011 | M | OR |
| 1012 | E | *00 BYTE AT LOC 100A TO PASS |
| 1013 | X | FILE CREATION/SEEK/LOAD FUNCTION |
| 1014 | X | TO REGULAR DOS |
| 1015 | X | |
| 1016 | DOS ENTRY MSB | } *DOS ENTRY POINT ADDRESS |
| 1017 | DOS ENTRY LSB | } JUMP VECTOR |
| 1018 | ERROR TYPE #1 ADDRESS MSB | } ERROR RECOVERY JUMP VECTOR #1 |
| 1019 | ERROR TYPE #1 ADDRESS LSB | } (ADDRESS OF RECOVERY ROUTINE) |
| 101A | ERROR TYPE #2 ADDRESS MSB | } ERROR RECOVERY JUMP VECTOR #2 |
| 101B | ERROR TYPE #2 ADDRESS LSB | } (ADDRESS OF RECOVERY ROUTINE) |
| 101C | COMS DISPLAY ADDRESS MSB | } COMMUNICATIONS DISPLAY ROUTINE |
| 101D | COMS DISPLAY ADDRESS LSB | } JUMP VECTOR |
| 101E | EXTENT CONTROL REG #1 | } SPECIAL FUNCTION EXTENT |
| 101F | EXTENT CONTROL REG #2 | } REGISTERS |

# FIG. 2. (CONTINUED)

TO HOST

FCI  FCO  ADDRESS BUS  EXTERNAL DATA BUS  R/W̄ STROBE

—17  —16

I/O DATA CONTROL

PSU & REF V  —15  250V AC

DIGITAL INPUT REGISTERS (nk)  DIGITAL INPUT REGISTERS (nk)  ftGEN A/D & D/A SECTION  NODE BOARD

62

DIGITAL PARAMETERS LATCH STORE

(255x32 BIT REG)

MICTR

—14

BASE ADDRESS SWITCH SET TO HEX 1000

RAM  μ-CODE ROM (INCL APL)

# FIG. 3.

CONTROL BUS

25 → 17

16M BYTE DIRECT

MPU 68000

MICTR ADDRESS BUS 23/

21

24 — BASE ADDRESS COUNTER

CHARGED PKT INTERNAL DATA BUS 19

21 — ADDRESS BUS

←— 16 BIT —→ FFFFFF

ROM μ CODE 40K

PARAMETER REGISTER WORK VECTOR | 8K LATCH REGISTER AREA FOR PARAMETER WORKSPACE

MICTR RAM (32K) VECTOR

STACK

16/

INPUT SOURCE BUFFER RAM (16K BYTES)

OUTPUT SOURCE BUFFER RAM (16K BYTES)

PARAMETER REGISTER VECTOR | 8K NON-VOLATILE PARAMETER STORE LATCH (256 x 32 BIT REGISTERS)

000 000

(EXTERNAL) TO/FROM HOST DATA BUS 16

DIGITAL DATA FAST I/O GATE

8/

FAST PUSH PULL GATE 32MHz RIPPLE-THROUGH DMA

21

ADDRESS

ANALOGUE FUNCTION STAGES D-A

ANALOGUE BUS

ANALOGUE BUS

ANALOGUE FUNCTION STAGES A-D

NODES
BI-DIRECTIONAL
SWITCHING NETWORK
TIME BASED FUNCTION
GENERATOR
ANALOGUE MATHEMATIC
STAGES

21

FIG. 4.

6/13

0063878

# FIG. 4a.

# FIG.12a.

FIG.5.

0063878

7/18

Labels: CTr CONTROL, INPUT, 70a, 70b, 70c, 70d, 70e, 70f, 70g (÷10 blocks), 72, 76, 74a, 74b, 74c, 78, carry, EXPONENT, 10, 10¹, 10²

# FIG. 6.

## BASE COUNTER RANGE

| INPUT COUNT | MANTISSA | EXPONENT |
|---|---|---|
| 0 | 000 | 0 |
| 1 | 001 | 0 |
| 999 | 999 | 0 |
| 1000 | 100 | 1 |
| 9999 | 999 | 1 |
| 10000 | 100 | 2 |
| 99999 | 999 | 2 |
| 100000 | 100 | 3 |
| 999999999 | 999 | 6 |
| 1000000000 | 100 | 7 |
| 9999999999 | 999 | 7 |
| 10000000000 | 100 | 8 |

## FIG. 7.

| | PHYSICAL BYTE LOCATIONS | MAP RATIO KEY | VOLUME ADDRESS | BYTES | |
|---|---|---|---|---|---|
| LEVEL 1. ACCESS PAGE STORE | 000-999 | ZERO | 0 | 1000 | } NODE 1 |
| LEVEL 2. ACCESS FOLDER STORE | 1000-9999 | 9:1 | 1 | 9000 | |
| | 10 000-99 999 | 90:1 | 2 | 90 000 | 2 |
| LEVEL 3. ACCESS DRAWER STORE | 10 000-999 999 | 900:1 | 3 | 900 000 | 3 |
| | 1 000 000-9 999 999 | 9000:1 | 4 | 9 000 000 | 4 |
| | 10 000 000-99 999 999 | 90 000:1 | 5 | 90 000 000 | 5 |
| | 100 000 000-999 999 999 | 900 000:1 | 6 | 900 000 000 | 6 |
| LEVEL 4. PERMANENT DRAWER STORE | 1 000 000 000-9 999 999 999 | 9 000 000:1 | 7 | 9 000 000 000 | 7 |

NODE 8=QUE DUMP ACCESS

FIG.8.

# FIG 9a

FIG. 9b.

0063878

# FIG. 18.

# FIG. 9c.

FIG.1O.

FIG.11.

# FIG.12b.

Probe Voltage

Input Voltage break points

→ Time

Comparator States

→ Time

# FIG.12c.

$V_e$ out

Time

Break Voltages and segments

$(V_e$ in$)$

# FIG.13.

Sample pulse or capacitor discharge pulse.

$C_N$

X

80

Y

IC2A

Sample and Hold input.

Integrator input.

−15V

# FIG.14.

NODE 1

oNODE 8 ACCESS (via sample and hold)
oInput
oDischarge
oRefresh
oOutput

N8●  ●N1  ●N2

N7●  ●N3
TSS

N6●  ●N4

●N5

V int.
(Q)

$z''$  $z'$

$z$

# FIG.15.

B1    B2    B3    Time
  b      b      b

b = inter-byte time between
integration periods for
successive bytes
B1, B2, B3 etc.

0063878

# FIG.16a.

# FIG.16b.

# FIG.17.

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 3) |
|---|---|---|---|
| A | PROCEEDINGS OF THE NATIONAL ELECTRONICS CONFERENCE, vol. 24, Conference 9th-11th December 1968, pages 251-256, Publisher: "National electronics conference, Inc." (USA); R.F.CRALL et al.: "Multiple-input memistor". *The whole document* | 1-3 | G 11 C 11/56 G 11 C 27/00 |
| A | INSTITUTE OF ELECTRICAL AND ELECTRONICS ENGINEERS, Proceedings of the international sympsosium on multiple-valued logic, Morgatown, 29th-30th May 1974, pages 457-468, Long Beach (USA); U.J.STRASILLA: "A multiple-valued memory system using capacitor storage". *The whole document* | 1 | |

TECHNICAL FIELDS SEARCHED (Int. Cl. 3)

G 11 C 11/56
G 11 C 27/00
G 06 F 13/00

The present search report has been drawn up for all claims

| Place of search | Date of completion of the search | Examiner |
|---|---|---|
| THE HAGUE | 24-06-1982 | DEGRAEVE L.W.G. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503. 03.82